# EUROPEAN PATENT APPLICATION

(11) **EP 4 782 852 A1**
(43) Date of publication of application: **29.07.2026**
(21) Application number: 25873849.1
(22) Date of filing: 21.08.2025
(51) Int. Cl.: G01R 31/367, G01R 31/36, G01R 31/382, G01R 31/396, G01R 31/392, G06F 17/18

(54) **BATTERY DIAGNOSIS DEVICE AND METHOD**

(30) Priority: 30.09.2024 KR 20240132588
(71) Applicant: LG Energy Solution, Ltd., Seoul 07335 (KR)
(72) Inventor: KIM, Huisu, Daejeon 34122 (KR); LEE, Sangmu, Daejeon 34122 (KR)
(74) Representative: Goddar, Heinz J.
(86) International application number: PCT/KR2025/012706
(87) International publication number: WO 2026/071488

(57) **Abstract**

A battery diagnosis device according to an embodiment of the present invention may comprise: at least one processor; and memory that stores at least one command that is executed through the at least one processor. Here, the at least one command may comprise: a command for acquiring state data including a state value of each of factors for a plurality of batteries; a command for deriving regression lines indicating relationships between the factors by using the state data; a command for calculating coordinates corresponding to the state values of the factors and distances between the regression lines; and a command for inputting diagnostic data including the distances into a pre-trained diagnostic model, and determining an abnormal battery among the batteries by using a diagnostic result output by the diagnostic model.

## Description

### [Technical Field]

This application claims priority to and the benefit of Korean Patent Application No.10-2024-0132588 filed in the Korean Intellectual Property Office on September 30, 2024 the entire contents of which are incorporated herein by reference.

The present invention relates to a battery diagnostic apparatus and method, and more particularly, to a battery diagnostic apparatus and method for diagnosing whether a battery is abnormal using an artificial intelligence-based diagnostic model.

### [Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery module in which a plurality of battery cells are connected in series/parallel or a battery pack in which battery modules are connected in series/parallel according to system requirements. For medium- to large-sized devices such as electric vehicles, a high-capacity battery system with a plurality of battery packs connected in parallel can be applied to satisfy required capacity of the system.

Battery cells are manufactured through assembly and activation processes. Since battery cells are assembled in a discharged state, an activation process is required after the assembly process to activate the positive electrode active material and form a solid electrolyte interface (SEI) on the negative electrode, enabling the battery to function. This activation process may also be called a formation process. The activation process may be performed by a charging/discharging device repeatedly charging/discharging the battery cells according to a preset charge/discharge profile.

Generally, to screen out defective batteries during the manufacturing process, state data such as battery cell voltage and current are collected during the activation process and may be used to identify defective batteries. For example, low-voltage defective batteries can be detected based on an amount of voltage drop measured during the activation process.

However, this typical diagnostic method can lead to normal batteries being classified as defective (over-inspection) or defective batteries being judged as normal (under-inspection).

Among the prior art documents relevant to the present invention, KR 10-2022-0039452 A is of some relevance.

### [Detailed Description of the Invention]

### [Technical Problem]

To obviate one or more problems of the related art, embodiments of the present disclosure provide a battery diagnostic apparatus capable of diagnosing battery abnormalities using an artificial intelligence-based diagnostic model.

To obviate one or more problems of the related art, embodiments of the present disclosure also provide a battery diagnostic method using the battery diagnostic apparatus.

To obviate one or more problems of the related art, embodiments of the present disclosure also provide a battery system including the battery diagnostic apparatus.

### [Technical Solution]

In order to achieve the objective of the present disclosure, a battery diagnostic apparatus may include at least one processor; and a memory configured to store at least one instruction executed by the at least one processor.

Here, the at least one instruction may include an instruction to obtain state data including state values of each of factors for a plurality of batteries; an instruction to derive a regression line representing relationship between the factors using the state data; an instruction to calculate the distance between a coordinate point corresponding to the state values of the factors and the regression line; and an instruction to input diagnostic data including the distance into a pre-trained diagnostic model and to determine an abnormal battery among the batteries using the diagnostic results output by the diagnostic model.

The factors may include one or more of: voltage, current, temperature, and capacity of the battery.

The instruction to derive the regression line may include an instruction to perform a predefined linear regression analysis using state values for each of the two factors, thereby deriving a regression line representing the relationship between the two factors.

The instruction to calculate the distance may include an instruction to calculate the vertical distance between two-dimensional coordinate point corresponding to the state values for each of the two factors and the regression line.

The instruction to derive the regression line may include an instruction to derive a plurality of combinations of two factors if there are three or more factors; and an instruction to derive a regression line for each of the combinations.

The diagnostic model may be pre-trained to output diagnostic result data indicating whether a low-voltage defect exists in a specific battery when diagnostic data for the battery is input.

The diagnostic data further may include one or more of: an average value of the distances for the plurality of batteries and a standard deviation value of the distances.

According to another embodiment of the present disclosure, a battery diagnostic method performed by a battery diagnostic apparatus may include obtaining state data including state values of each of factors for a plurality of batteries; deriving a regression line representing relationship between the factors using the state data; calculating the distance between a coordinate point corresponding to the state values of the factors and the regression line; and inputting diagnostic data including the distance into a pre-trained diagnostic model and to determining an abnormal battery among the batteries using the diagnostic results output by the diagnostic model.

The factors may include one or more of: voltage, current, temperature, and capacity of the battery.

The deriving of the regression line may include performing a predefined linear regression analysis using state values for each of the two factors, thereby deriving a regression line representing the relationship between the two factors.

The calculating of the distance may include calculating the vertical distance between two-dimensional coordinate point corresponding to the state values for each of the two factors and the regression line.

The deriving of the regression line may include deriving a plurality of combinations of two factors if there are three or more factors; and deriving a regression line for each of the combinations.

The diagnostic model may be pre-trained to output diagnostic result data indicating whether a low-voltage defect exists in the battery when diagnostic data for a specific battery is input.

The diagnostic data further may include one or more of: an average value of the distances for the plurality of batteries and a standard deviation value of the distances.

According to another embodiment of the present disclosure, a battery diagnostic system may include a data collection apparatus configured to collect state data including status values of each factor for a plurality of batteries; and a battery diagnostic apparatus configured to obtain the state data from the data collection apparatus and to diagnose whether the batteries are abnormal using the state data.

Here, the battery diagnostic apparatus derives a regression line representing relationship between the factors using the state data, calculates the distance between a coordinate point corresponding to the state values of the factors and the regression line, and uses the calculated distance and a pre-learned diagnostic model to determine which batteries are abnormal.

### [Advantageous Effects]

According to embodiments of the present disclosure, diagnostic accuracy can be improved by detecting abnormal batteries using an artificial intelligence-based diagnostic model.

### [Brief Description of the Drawings]

FIG. 1 is a reference diagram illustrating a general battery diagnostic method.
FIG. 2 is a block diagram illustrating a battery diagnostic system according to embodiments of the present invention.
FIG. 3 is a block diagram illustrating a battery diagnostic apparatus and a diagnostic model generation apparatus according to embodiments of the present invention.
FIGS. 4 to 7 are reference diagrams illustrating a diagnostic model according to embodiments of the present invention.
FIG. 8 is an operational flowchart illustrating a battery diagnostic method according to embodiments of the present invention.
FIG. 9 is a block diagram of a battery diagnostic apparatus according to embodiments of the present invention.

10: battery
100: data collection apparatus
200, 900: battery diagnostic apparatus
300: diagnostic model generation apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

State of Charge (SOC) refers to a current state of charge of a battery, represented in percent points [%], and State of Health (SOH) may be a current condition of a battery compared to its ideal or original conditions, represented in percent points [%].

A battery cell is a basic unit that serves to store power and a battery module refers to an assembly in which a plurality of battery cells is electrically connected.

A battery rack refers to a system of a single structure which is assembled by connecting module units set by a battery manufacturer in series/parallel and may be monitored and controlled by a battery management apparatus/system (BMS). A battery rack may include several battery modules and a battery protection unit or any other protection device. Here, the battery module may also be referred to as a battery pack depending on a device or system in which the battery is used.

A battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

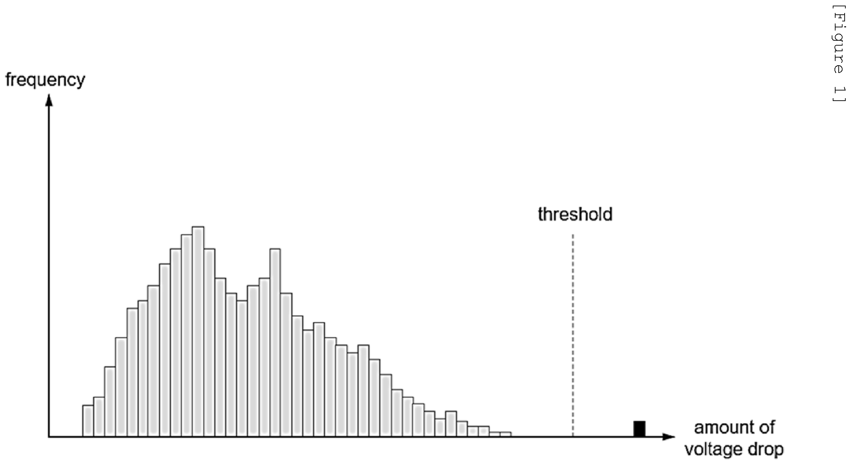

FIG. 1 is a reference diagram illustrating a general battery diagnostic method.

Generally, state data such as battery cell voltage and current values are collected during an activation process to screen out defective batteries during a manufacturing process and used to screen out defective batteries.

For example, a battery diagnostic apparatus collects the open circuit voltage (OCV) of each battery cell measured during the activation process. As illustrated in FIG. 1, the battery diagnostic apparatus then screens out battery cells whose voltage drop exceeds a preset threshold and determine these cells as low-voltage defective cells.

This typical diagnostic method, based on statistics of specific state values, does not consider various factors, resulting in limited diagnostic accuracy. Consequently, this diagnostic method can result in normal batteries being screened as defective(over-inspection), or defective batteries being judged as normal(under-inspection).

The present invention has been developed to address these issues and various embodiments of the present invention will be described in detail below with reference to the attached drawings.

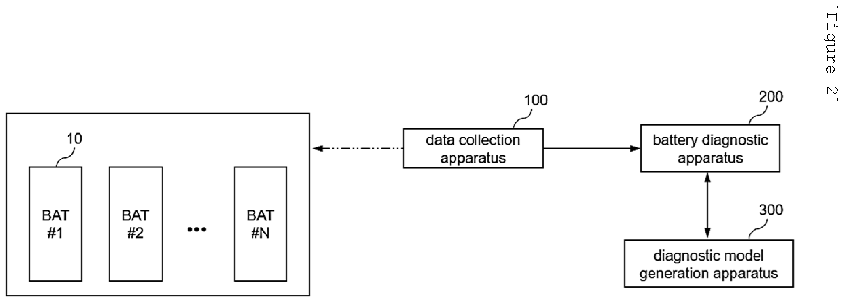

FIG. 2 is a block diagram illustrating a battery diagnostic system according to embodiments of the present invention.

Referring to FIG. 2, the battery diagnostic system may include a plurality of batteries 10 BAT #1 to BAT #N, a data collection apparatus 100, a battery diagnostic apparatus 200, and a diagnostic model generation apparatus 300.

In the present disclosure, the battery 10 may refer to a battery cell, but the scope of the present invention is not limited thereto. In other words, the battery diagnostic apparatus 200 according to embodiments of the present invention may perform diagnosis on a battery module, battery pack, battery rack, or battery bank in addition to a battery cell.

Each of the batteries 10 may be electrically connected to a charging/discharging device or a charging/discharging circuit. Here, the batteries 10 may be charged according to a predefined charging profile or charging map.

The data collection apparatus 100 may collect state data for each battery.

The state data may include state variables for each of a plurality of factors. Here, the factors may include one or more of the voltage, current, temperature, and capacity of the battery. For example, the data collection apparatus 100 may collect state data including one or more of the OCV value, current value, temperature value, and capacity value of each battery cell measured during an activation process. For another example, the data collection apparatus 100 may collect state data including one or more of the OCV value, current value, temperature value, and capacity value of each battery module measured during an operation of the battery system.

The data collection apparatus 100 may provide the collected state data to the battery diagnostic apparatus 200.

The battery diagnostic apparatus 200 may use the battery state data provided by the data collection apparatus 100 to diagnose whether each battery 10 is abnormal. Here, the battery diagnostic apparatus 200 may detect a battery among a plurality of batteries 10 that has a predefined abnormal condition. For example, the battery diagnostic apparatus 200 may detect a low-voltage, defective battery among the plurality of batteries 10.

The battery diagnostic apparatus 200 may be included in activation process equipment or a battery management system (BMS) located within the battery system. In other words, the battery diagnostic system according to embodiments of the present invention may be applied to an activation process to detect defective battery cells during a battery manufacturing process, or applied to a battery system to detect defective battery cells or defective battery assemblies during operation of a battery system.

The battery diagnostic apparatus 200 may generate diagnostic data from state data according to a predefined data processing process and use the diagnostic data and a pre-learned diagnostic model to determine a defective battery among the batteries.

The diagnostic model may be generated by a diagnostic model generation apparatus 300. Here, the diagnostic model generation apparatus 300 may train a predefined diagnostic model using pre-collected training data and provide the trained diagnostic model to the battery diagnostic apparatus 200. Here, the diagnostic model may be pre-trained to output diagnostic result data indicating whether a specific battery has a low-voltage defect when diagnostic data for the corresponding battery is input.

The battery diagnostic apparatus 200 may input the diagnostic data into the diagnostic model and use diagnostic results output by the diagnostic model to determine which battery is abnormal among the batteries.

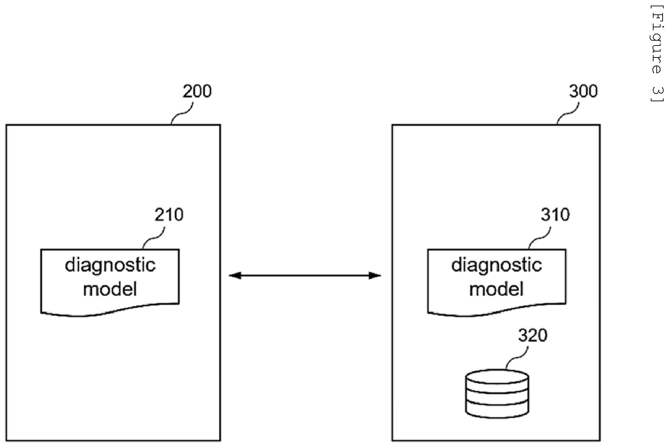

FIG. 3 is a block diagram illustrating a battery diagnostic apparatus and a diagnostic model generation apparatus according to embodiments of the present invention.

The battery diagnostic apparatus 200 may use a pre-trained diagnostic model 210 to determine a faulty battery among batteries. Here, the battery diagnostic apparatus 200 may receive a trained diagnostic model 310 from the diagnostic model generation apparatus 200.

The battery diagnostic apparatus 200 may obtain state data, including state values of each factor for the batteries, from the data collection apparatus 100 of FIG. 2 and process the state data according to a predefined data processing process to generate input data (diagnostic data) applied to the diagnostic model 210. Thereafter, the battery diagnostic apparatus 200 may input the diagnostic data into the diagnostic model 210 and use diagnostic results (output data) output from the diagnostic model 210 to determine a faulty battery among the batteries.

The diagnostic model generation apparatus 300 may train a machine learning-based diagnostic model 310 using training data stored in a storage device 320. Here, the diagnostic model 310 may be trained to output diagnostic result data indicating whether a specific battery exhibits a low-voltage defect when receiving diagnostic data for the specific battery.

Once training of the diagnostic model 310 is complete, the diagnostic model generation apparatus 300 may provide the trained diagnostic model 310 to the battery diagnostic apparatus 200.

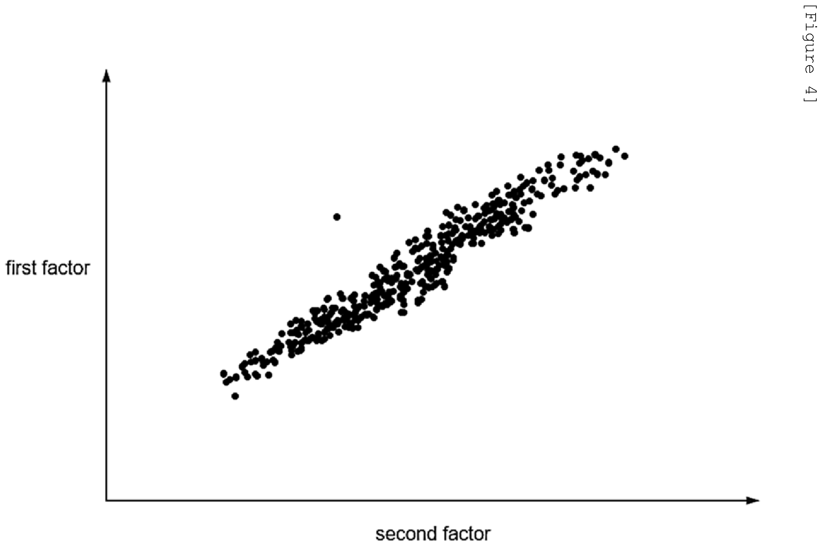

FIGS. 4 to 7 are reference diagrams illustrating a diagnostic model according to embodiments of the present invention.

The diagnostic model generation apparatus 300 may collect raw data for training the diagnostic model 310. Here, the raw data may include state data including state values of each factor for a plurality of batteries and diagnostic result data indicating whether the batteries are abnormal. The diagnostic model generation apparatus 300 may obtain the raw data from the data collection apparatus 100.

The factors may include one or more of the voltage, current, temperature, and capacity of the battery. For example, the state data may include a first OCV value (state value of a first factor) of each battery cell measured after completion of the first charging cycle during an activation process, and a second OCV value (state value of a second factor) of each battery cell measured after completion of the second charging cycle during the activation process. For another example, the state data may include the OCV value (state value of a first factor), current value (state value of a second factor), temperature value (state value of a third factor), and capacity value (state value of a fourth factor) of each battery cell measured during the activation process. For another example, the state data may include the OCV value (state value of a first factor), current value (state value of a second factor), temperature value (state value of a third factor), and capacity value (state value of a fourth factor) of each battery module measured during operation of the battery system.

The diagnostic model generation apparatus 300 may process raw data according to a predefined data processing process to generate learning data for training the diagnostic model 310. Here, the learning data may include distances between a coordinate point corresponding to the state values of factors (hereinafter, "coordinate point of state values") and a regression line representing relationship between factors, and diagnostic result data indicating whether the battery is abnormal (e.g., whether there is a low voltage failure).

Specifically, the diagnostic model generation apparatus 300 may derive a regression line representing the relationship between a plurality of factors using the state data. Here, the diagnostic model generation apparatus 300 may perform a predefined linear regression analysis using the state values for each of two factors and derive a regression line representing relationship between the two factors.

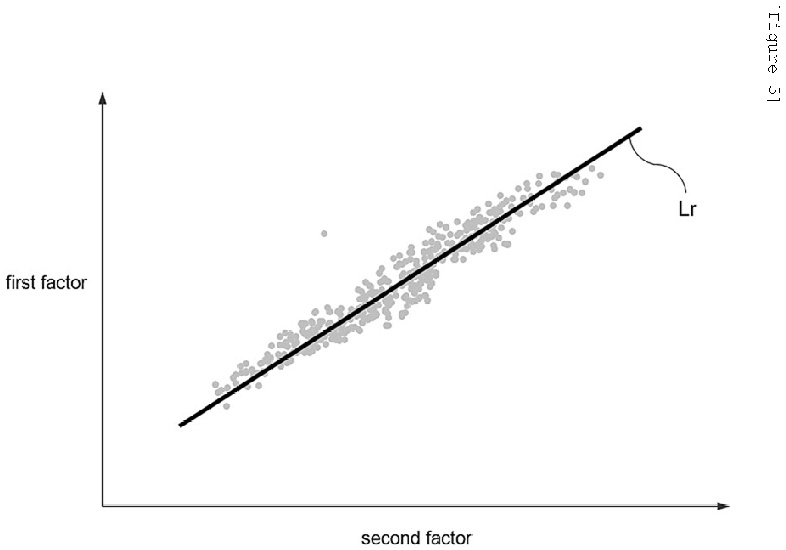

For example, if the raw data includes a first OCV value (state value of a first factor) measured after the completion of the first charging cycle during an activation process for each of a plurality of battery cells, and a second OCV value (state value of a second factor) measured after the completion of the second charging cycle during the activation process, the diagnostic model generation apparatus 300 may define the first factor as the X-axis and the second factor as the Y-axis, as illustrated in FIG. 4, and may convert the state values of the first factor and the state values of the second factor into two-dimensional coordinates for each of the battery cells. Thereafter, the diagnostic model generation apparatus 300 may derive a regression line Lr that estimates the relationship between the first factor and the second factor by performing a predefined linear regression analysis using the coordinates of the state values for the battery cells, as illustrated in FIG. 5.

Thereafter, the diagnostic model generation apparatus 300 may calculate the distance between the coordinate point of the state values for each battery cell and the regression line. Here, the diagnostic model generation apparatus 300 may calculate the vertical distance D between the two-dimensional coordinate point corresponding to the state values of each of the two factors and the regression line Lr.

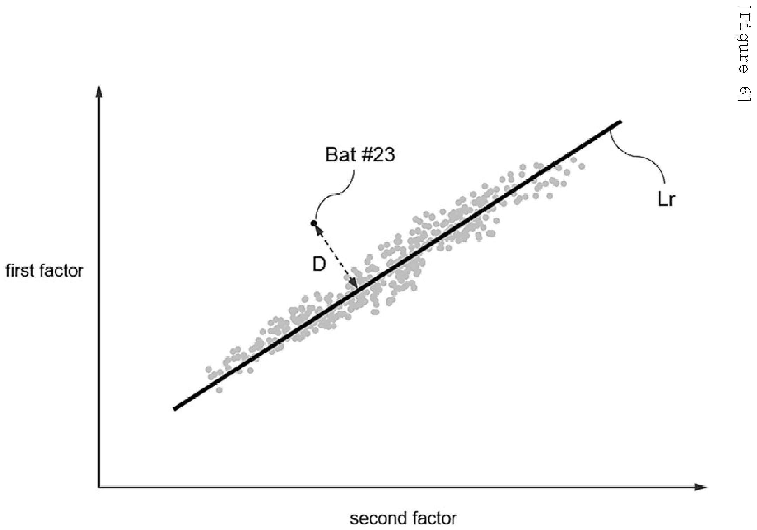

For example, as illustrated in FIG. 6, the diagnostic model generation apparatus 300 may calculate the vertical distance (or shortest distance) D between the coordinate point of the state values and the regression line Lr for a specific battery cell (Bat #23). Here, the diagnostic model generation apparatus 300 may calculate the vertical distance D for each of all the battery cells.

The diagnostic model generation apparatus 300 may train the diagnostic model 310 using training data, including the distances D between the coordinate points of the state values and the regression line for a plurality of batteries and diagnostic result data indicating whether the battery is abnormal.

In an embodiment, when state values for three or more factors are included in the raw data, the diagnostic model generation apparatus 300 may derive a plurality of combinations composed of two factors and derive a regression line for each combination. Thereafter, the diagnostic model generation apparatus 300 may calculate, for each of the regression lines, distances D1 to DN between the coordinate points of the state values and the regression lines. Here, the distances D1 to DN between the coordinate points of the state values and the regression lines calculated for each of the regression lines may be included in the learning data.

For example, if the raw data includes an OCV value (state value of a first factor) measured after completion of the activation process for each of a plurality of battery cells, a current value (state value of a second factor) measured at a specific point in time during the activation process, and a capacity value (state value of a third factor) measured after completion of the activation process, the diagnostic model generation apparatus 300 may derive a plurality of combinations consisting of two factors, [first factor, second factor], [first factor, third factor], and [second factor, third factor], from the three factors.

For another example, if the raw data includes an OCV value (state value of a first factor) measured at a first point in time after completion of the activation process for each of a plurality of battery cells, an OCV value (state value of a second factor) measured at a second point in time (a point in time after t period from the first point in time) after completion of the activation process, and an OCV value (state value of a third factor) measured at a third point in time (a point in time after t period from the second point in time) after completion of the activation process, the diagnostic model generation apparatus 300 may derive a plurality of combinations consisting of two factors, [first factor, second factor], [first factor, third factor], and [second factor, third factor], from the three factors.

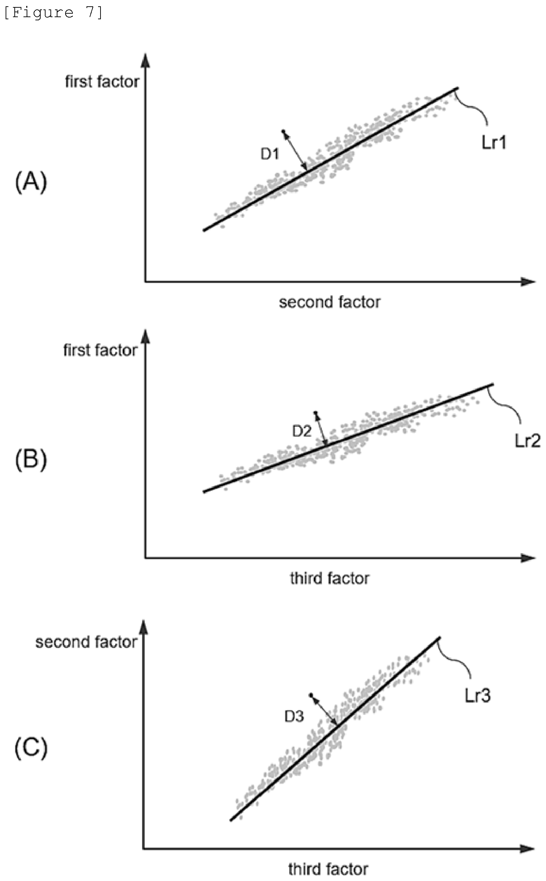

Thereafter, the diagnostic model generation apparatus 300 may derive a first regression line Lr1 representing the relationship between the first factor and the second factor, as illustrated in FIG. 7(A), and calculate a first distances D1 between the state value coordinate point of the first factor and the second factor and the first regression line Lr1 for all battery cells. In addition, the diagnostic model generation apparatus 300 may derive a second regression line Lr2 representing the relationship between the first factor and the third factor, as illustrated in FIG. 7(B), and calculate a second distances D2 between the state value coordinate point of the first factor and the third factor and the second regression line Lr2 for all battery cells. Furthermore, the diagnostic model generation apparatus 300, as illustrated in FIG. 7(C), may derive a third regression line Lr3 representing the relationship between the second and third factors, and calculate a third distances D3 between the state value coordinate point of the second and third factors and the third regression line Lr3 for all battery cells.

Thereafter, the diagnostic model generation apparatus 300 may train the diagnostic model 310 using training data including the first distance D1, the second distance D2, the third distance D3, and diagnostic result data indicating whether the battery is abnormal for a plurality of batteries.

In an embodiment, the training data may further include one or more of an average value (Av) of the distances D between the state value coordinate point and the regression line, and a standard deviation value (S) of the distances D.

For example, the diagnostic model generation apparatus 300 may calculate a distance average value (Av) and a standard deviation value (S) based on the distance D from the regression line for each of the plurality of batteries, and train the diagnostic model 310 by reflecting the calculated distance average value (Av) and standard deviation value (S) to the training data.

For another example, the diagnostic model generation apparatus 300 may calculate a first distance average value (Av1) and a first standard deviation value (S1) based on the first distances D1 between the state value coordinate points of the first and second factors for each of the plurality of batteries and the first regression line. Furthermore, the diagnostic model generation apparatus 300 may calculate a second distance average value (Av2) and a second standard deviation value (S2) based on the second distances D2 between the state value coordinate points of the first and third factors for each of the plurality of batteries and the second regression line. In addition, the diagnostic model generation apparatus 300 may calculate a third distance average value (Av3) and a third standard deviation value (S3) based on the third distances D3 between the state value coordinate points of the second and third factors for each of the plurality of batteries and the third regression line. Thereafter, the diagnostic model generation apparatus 300 may train the diagnostic model 310 by reflecting the first to third distance average values (Av1 to Av3) and the first to third standard deviation values (S1 to S3) to the training data.

When the training of the diagnostic model 310 is completed, the diagnostic model generation apparatus 300 may provide the trained diagnostic model 310 to the battery diagnostic apparatus 200.

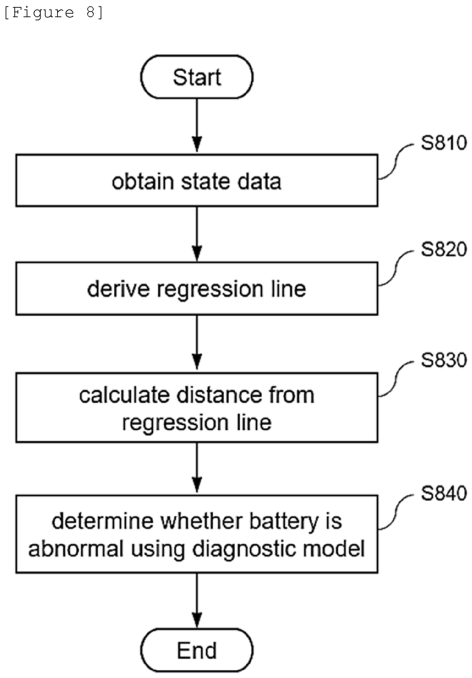

FIG. 8 is an operational flowchart illustrating a battery diagnostic method according to embodiments of the present invention.

While the following describes a battery diagnostic method targeting a single battery as an example, the battery diagnostic method according to embodiments of the present invention may be performed on each of a plurality of batteries, thereby detecting one or more abnormal batteries battery among a plurality of batteries.

The battery diagnostic apparatus may obtain state data including state values of each factor for a plurality of batteries (S810). Here, the battery diagnostic apparatus may obtain state data for each battery from a data collection apparatus.

The factors may include one or more of the following: voltage, current, temperature, and capacity of the battery.

The battery diagnostic apparatus may collect state data corresponding to learning data of the diagnostic model. For example, if the diagnostic model is pre-trained based on a first OCV value (state value of a first factor) of each battery cell measured after the completion of the first charging cycle during an activation process and a second OCV value (state value of a second factor) of each battery cell measured after completion of the second charging cycle during the activation process, the battery diagnostic apparatus may collect state data including the state values of the first factor and the second factor. As another example, if the diagnostic model is pre-trained based on an OCV value (state value of a first factor), a current value (state value of a second factor), and a capacity value (state value of a third factor) of each battery cell measured during an activation process, the battery diagnostic apparatus may collect state data including the state values of the first factor, the state values of the second factor, and the state values of the third factor.

The battery diagnostic apparatus may derive a regression line representing relationship between factors using the state data acquired in S810 (S820). Here, the battery diagnostic apparatus may perform a predefined linear regression analysis using the state values for each of the two factors and derive a regression line representing the relationship between the two factors.

For example, if the state data includes a first OCV value (state value of the first factor) measured after completion of a first charging cycle during an activation process for each of a plurality of battery cells, and a second OCV value (state value of the second factor) measured after completion of a second charging cycle during the activation process, the battery diagnostic apparatus may define a first factor as the X-axis and a second factor as the Y-axis, as illustrated in FIG. 4, and convert the state values of the first factor and the second factor into two-dimensional coordinates for each of the battery cells. Thereafter, the battery diagnostic apparatus may derive a regression line Lr estimating relationship between the first factor and the second factor by performing a predefined linear regression analysis using the coordinates of the state values for the battery cells, as illustrated in FIG. 5.

The battery diagnostic apparatus may calculate the distance between a coordinate point of the state values and the regression line for a specific battery (S830). Here, the battery diagnostic apparatus may calculate a vertical distance D between the two-dimensional coordinate point corresponding to the state values of each of the two factors and the regression line Lr.

For example, as illustrated in FIG. 6, the battery diagnostic apparatus may calculate a vertical distance D (or shortest distance) between a coordinate point of the state values and the regression line Lr for a specific battery cell (Bat #23).

The battery diagnostic apparatus may use the distance D between the coordinate point of the state values and the regression line, calculated in S830, and a pre-trained diagnostic model to determine whether the battery is abnormal (S840).

More specifically, the battery diagnostic apparatus may input diagnostic data including the distance D calculated in S830 into a pre-stored diagnostic model. Here, the diagnostic model has been pre-trained, upon receiving diagnostic data for a specific battery, to output diagnostic result data (e.g., OK or NG) indicating whether the battery is abnormal (e.g., low voltage defect), and the diagnostic model may be stored in a storage device in the battery diagnostic apparatus. Accordingly, the battery diagnostic apparatus may determine whether the battery is abnormal by checking diagnostic result data output by the diagnostic model.

In embodiments, if the state data includes state values for three or more factors, the battery diagnostic apparatus may derive a plurality of combinations of two factors and derive a regression line for each of the combinations. Thereafter, the battery diagnostic apparatus may calculate distances D1 to DN between a coordinate points of the state values and the regression lines for each of the regression lines.

For example, if the state data includes an OCV value measured after an activation process (state value of a first factor) for each of the plurality of battery cells, a current value measured at a specific point during the activation process (state value of a second factor), and a capacity value measured after the activation process (state value of a third factor), the battery diagnostic apparatus may derive a plurality of combinations of two factors from the three factors: [first factor, second factor], [first factor, third factor], and [second factor, third factor].

For another example, if the state data includes, for each of a plurality of battery cells, an OCV value (state value of a first factor) measured at a first point in time after completion of an activation process, an OCV value (state value of a second factor) measured at a second point in time (a point in time after t period from the first point in time) after completion of the activation process, and an OCV value (state value of the third factor) measured at a third point in time (a point in time after t period from the second point in time) after completion of the activation process, the battery diagnostic apparatus may derive, from the three factors, a plurality of combinations consisting of two factors, [first factor, second factor], [first factor, third factor], and [second factor, third factor].

Thereafter, the battery diagnostic apparatus may derive a first regression line Lr1 representing relationship between the first factor and the second factor, as illustrated in FIG. 7(A), and calculate a first distance D1 between the first regression line Lr1 and the state value coordinate point of the first factor and the second factor. In addition, the battery diagnostic apparatus may derive second regression line Lr2 representing relationship between the first factor and the third factor, as illustrated in FIG. 7(B), and calculate a second distance D2 between the second regression line Lr2 and the state value coordinate point of the first factor and the third factor. In addition, the battery diagnostic apparatus may derive a third regression line Lr3 representing the relationship between the second factor and the third factor, as illustrated in FIG. 7(C), and calculate a third distance D3 between the state value coordinate point of the second factor and the third factor, and third regression line Lr3.

Thereafter, the battery diagnostic apparatus may input diagnostic data including the first to third distances D1 to D3 into a pre-stored diagnostic model and check the diagnostic result data output by the diagnostic model to determine whether the battery is defective.

In another embodiment, the diagnostic data may further include one or more of an average value (Av) of distances D between the coordinate point of the state values and the regression line, and the standard deviation value (S) of the distances D.

For example, the battery diagnostic apparatus may calculate an average distance value (Av) and the standard deviation value (S) based on the distances D from the regression line for each of a plurality of batteries, and include the calculated average distance value (Av) and the standard deviation value (S) in the diagnostic data. Thereafter, the battery diagnostic apparatus may input diagnostic data including the distance D between the coordinate point of the state values and the regression line for a specific battery, the average distance value (Av), and the standard deviation value (S) into the diagnostic model and check diagnostic result data output by the diagnostic model to determine whether the battery is defective.

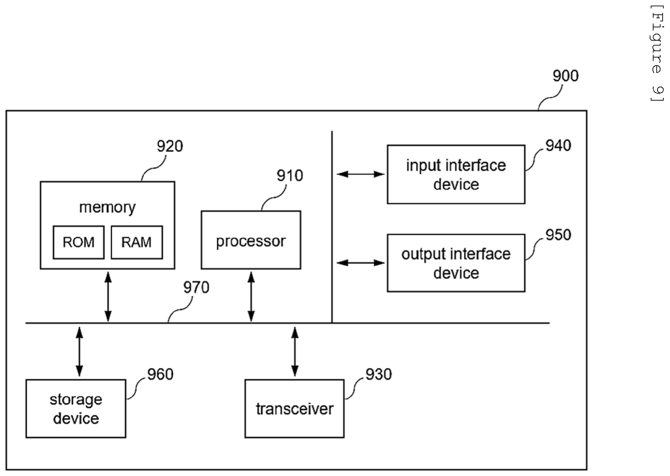

FIG. 9 is a block diagram of a battery diagnostic apparatus according to embodiments of the present invention.

The battery diagnostic apparatus 900 according to embodiments of the present invention may include at least one processor 910, a memory 920 configured to store at least one instruction executed through the processor, and a transceiver 930 that is connected to a network and performs communication.

The at least one instruction may include an instruction to obtain state data including state values of each of factors for a plurality of batteries; an instruction to derive a regression line representing relationship between the factors using the state data; an instruction to calculate the distance between a coordinate point corresponding to the state values of the factors and the regression line; and an instruction to input diagnostic data including the distance into a pre-trained diagnostic model and to determine an abnormal battery among the batteries using the diagnostic results output by the diagnostic model.

The factors may include one or more of: voltage, current, temperature, and capacity of the battery.

The instruction to derive the regression line may include an instruction to perform a predefined linear regression analysis using state values for each of the two factors, thereby deriving a regression line representing the relationship between the two factors.

The instruction to calculate the distance may include an instruction to calculate the vertical distance between two-dimensional coordinate point corresponding to the state values for each of the two factors and the regression line.

The instruction to derive the regression line may include an instruction to derive a plurality of combinations of two factors if there are three or more factors; and an instruction to derive a regression line for each of the combinations.

The diagnostic model may be pre-trained to output diagnostic result data indicating whether a low-voltage defect exists in a specific battery when diagnostic data for the battery is input.

The diagnostic data further may include one or more of: an average value of the distances for the plurality of batteries and a standard deviation value of the distances.

Furthermore, the battery diagnostic apparatus 900 according to embodiments of the present invention may further include an input interface device 940, an output interface device 950, a storage device 960, etc. Respective components included in the battery diagnostic apparatus 900 may be connected by a bus 970 and can communicate with each other.

Here, the processor 910 may mean a central processing unit (CPU), a graphics processing unit (GPU), or a dedicated processor on which methods according to embodiments of the present invention are performed. Furthermore, the memory may include one or more of a volatile/transitory recording medium and a nonvolatile/non-transitory recording medium. For example, the memory may include at least one of a read-only memory (ROM) and a random access memory (RAM), and may include an Electrically Erasable Programmable Read-only Memory (EEPROM) .

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

The operations of the method according to embodiments of the present invention may be implemented in various forms related to programs, such as a computer program or code itself, or a computer program product.

Furthermore, the computer-readable recording medium may include one or more of a volatile/transitory recording medium and a non-volatile/non-transitory recording medium.

In addition, the computer-readable recording medium may include hardware devices specially configured to store and execute program instructions, such as ROM, RAM, flash memory, and may include, for example, various types of servers located on a network. The program instructions may include not only machine language codes, such as those created by a compiler, but also high-level language codes that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery diagnostic apparatus comprising:
at least one processor; and
a memory configured to store at least one instruction executed by the at least one processor,
wherein the at least one instruction includes:
an instruction to obtain state data including state values of each of factors for a plurality of batteries;
an instruction to derive a regression line representing relationship between the factors using the state data;
an instruction to calculate the distance between a coordinate point corresponding to the state values of the factors and the regression line; and
an instruction to input diagnostic data including the distance into a pre-trained diagnostic model and to determine an abnormal battery among the batteries using the diagnostic results output by the diagnostic model.

2. The battery diagnostic apparatus of claim 1, wherein the factors include one or more of:
voltage, current, temperature, and capacity of the battery.

3. The battery diagnostic apparatus of claim 1, wherein the instruction to derive the regression line includes:
an instruction to perform a predefined linear regression analysis using state values for each of the two factors, thereby deriving a regression line representing the relationship between the two factors.

4. The battery diagnostic apparatus of claim 3, wherein the instruction to calculate the distance includes:
an instruction to calculate the vertical distance between two-dimensional coordinate point corresponding to the state values for each of the two factors and the regression line.

5. The battery diagnostic apparatus of claim 3, wherein the instruction to derive the regression line includes:
an instruction to derive a plurality of combinations of two factors if there are three or more factors; and
an instruction to derive a regression line for each of the combinations.

6. The battery diagnostic apparatus of claim 1, wherein the diagnostic model is pre-trained to output diagnostic result data indicating whether a low-voltage defect exists in a specific battery when diagnostic data for the battery is input.

7. The battery diagnostic apparatus of claim 1, wherein the diagnostic data further includes one or more of:
an average value of the distances for the plurality of batteries and a standard deviation value of the distances.

8. A battery diagnostic method performed by a battery diagnostic apparatus, the battery diagnostic method comprising:
obtaining state data including state values of each of factors for a plurality of batteries;
deriving a regression line representing relationship between the factors using the state data;
calculating the distance between a coordinate point corresponding to the state values of the factors and the regression line; and
inputting diagnostic data including the distance into a pre-trained diagnostic model and to determining an abnormal battery among the batteries using the diagnostic results output by the diagnostic model.

9. The battery diagnostic method of claim 8, wherein the factors include one or more of:
voltage, current, temperature, and capacity of the battery.

10. The battery diagnostic method of claim 8, wherein the deriving the regression line includes:
performing a predefined linear regression analysis using state values for each of the two factors, thereby deriving a regression line representing the relationship between the two factors.

11. The battery diagnostic method of claim 10, wherein the calculating the distance includes:
calculating the vertical distance between two-dimensional coordinate point corresponding to the state values for each of the two factors and the regression line.

12. The battery diagnostic method of claim 10, wherein the deriving the regression line includes:
deriving a plurality of combinations of two factors if there are three or more factors; and
deriving a regression line for each of the combinations.

13. The battery diagnostic method of claim 8, wherein the diagnostic model is pre-trained to output diagnostic result data indicating whether a low-voltage defect exists in a specific battery when diagnostic data for the battery is input.

14. The battery diagnostic method of claim 8, wherein the diagnostic data further includes one or more of:
an average value of the distances for the plurality of batteries and a standard deviation value of the distances.

15. A battery diagnostic system comprising:
a data collection apparatus configured to collect state data including status values of each factor for a plurality of batteries; and
a battery diagnostic apparatus configured to obtain the state data from the data collection apparatus and to diagnose whether the batteries are abnormal using the state data,
wherein the battery diagnostic apparatus derives a regression line representing relationship between the factors using the state data, calculates the distance between a coordinate point corresponding to the state values of the factors and the regression line, and uses the calculated distance and a pre-learned diagnostic model to determine which batteries are abnormal.
